(19)

**Europäisches Patentamt**
**European Patent Office**
**Office européen des brevets**

(11) **EP 4 675 288 A1**

(12) **EUROPEAN PATENT APPLICATION**
published in accordance with Art. 153(4) EPC

(43) Date of publication:
07.01.2026 Bulletin 2026/02

(21) Application number: 23924708.3

(22) Date of filing: 10.03.2023

(51) International Patent Classification (IPC):
*G01R 31/327* (2006.01)    *H01H 35/26* (2006.01)
*H01H 35/32* (2006.01)

(52) Cooperative Patent Classification (CPC):
G01R 1/02; G01R 31/327; G06F 30/20;
H01H 35/26; H01H 35/32

(86) International application number:
PCT/CN2023/080747

(87) International publication number:
WO 2024/178742 (06.09.2024 Gazette 2024/36)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 02.03.2023 CN 202310190622

(71) Applicant: Shanghai Roye Electric Co., Ltd.
Shanghai 201802 (CN)

(72) Inventors:
• JIN, Haiyong
Shanghai 201802 (CN)
• HUANG, Xiaobeng
Shanghai 201802 (CN)
• YE, Lingsong
Shanghai 201802 (CN)

(74) Representative: Huang, Liwei
Cäcilienstraße 12
40597 Düsseldorf (DE)

(54) **SIMULATION VERIFICATION METHOD AND APPARATUS FOR GAS DENSITY RELAY**

(57)    Embodiments of the present disclosure relate to a method and device for simulative calibration of a gas density relay. The method includes: obtaining a simulative detection signal value of the gas density relay at a temperature $T$, and obtaining a compensation quantity at the temperature $T$; obtaining a contact operation pressure value of the gas density relay at the temperature $T$ according to the compensation quantity and a contact operation value of the gas density relay at a normal temperature; obtaining an operation value of the gas density relay at a temperature value $T$ based on the contact operation pressure value and the temperature value $T$ by conversion according to a pressure-temperature characteristic relation of a gas to be detected; and calibrating the gas density relay according to the operation value. The technical solutions of the embodiments of the present disclosure allow for calibration of the gas density relay with the simulative detection signals and do not require disassembly of the gas density relay. The detection process is safe without manual intervention, and the obtained calibration result is highly accurate.

FIG.3

## Description

### Cross-Reference To Related Application

The present application claims priority to Chinese Patent Application No. 2023101906224 filed on March 2, 2023, which is incorporated herein by reference in its entirety.

### Technical Field

Embodiments of the present disclosure relate to the technical field of electrical equipment monitoring, and in particular, to a method and device for simulative calibration of a gas density relay.

### Background Art

Electrical equipment serves as a critical material foundation for ensuring the safe operation of power grids and the reliable supply of electricity. With the development of economy, the capacity of power systems has expanded rapidly, and the usage of related equipment has surged, making it increasingly important to ensure the safe and reliable operation of the power systems. $SF_6$, as an excellent insulating/arc-extinguishing gas, is widely used in high voltage applications. Currently, the vast majority of high-voltage equipment on the market employs $SF_6$ as the insulating/arc-extinguishing gas. The $SF_6$ gas content in $SF_6$ equipment directly affects the insulating/arc-extinguishing performance. If leakage occurs during use, it may significantly affect the safe and reliable operation of the electrical equipment.

Currently, mechanical density relays commonly used at present often exhibit some problems during use. For example, surface oxidation, mechanism jamming, and damage often happen if the contacts of $SF_6$ gas density relays installed on site do not operate for a long time. This may prevent the relays from issuing alarm/lockout signals, making it difficult for maintenance personnel to identify problems in a timely manner. Additionally, periodic calibration of SF6 gas density relays has the following problems: The large number of SF6 electrical equipment requires substantial annual manpower and material resources for regular calibration. For old equipment in some unrenovated substations, the lack of calibration interfaces (due to outdated design) often necessitates on-site disassembly of density relays during calibration. The assembly and disassembly process is inefficient and may compromise the original sealing performance, potentially causing gas leakage. Some density relays are installed at elevated positions, making assembly, disassembly, or on-site calibration difficult and posing safety risks. In addition, data recorded during calibration is often manually written, which is prone to omissions or mistakes. Moreover, for some renovated or newly built substations that employ non-disassembly on-site calibration methods, electrical signal circuits need to be disconnected. During live-line work, this may trigger false alarms or lockout signals for relay protection, preventing circuit breakers from operating correctly and, in severe cases, leading to vicious accidents.

### Summary of the Invention

In view of the above problems of the prior art, an objective of the embodiments of the present disclosure is to provide a method and device for simulative calibration of a gas density relay. The method and device allow for calibration of the gas density relay with simulative detection signals and do not require disassembly of the gas density relay. The detection process is safe without manual intervention, and the obtained calibration result is highly accurate.

To achieve the above objective, according to one aspect of the present disclosure, provided is a method for simulative calibration of a gas density relay, including:

obtaining a simulative detection signal value $P_{TFZDZ}$ of the gas density relay at a temperature T, and obtaining a compensation quantity $\Delta P$ at the temperature T according to the simulative detection signal value $P_{TFZDZ}$ and a simulative detection signal value $P_{20FZCS}$ of the gas density relay at a normal temperature;

obtaining an alarm contact operation pressure value $P_{TBJDZ}$ and/or a lockout contact operation pressure value $P_{TBSDZ}$ of the gas density relay at the temperature $T$ according to the compensation quantity $\Delta P$ and an alarm contact operation value $P_{20BJDZCS}$ and/or a lockout contact operation value $P_{20BSDZCS}$ of the gas density relay at the normal temperature;

obtaining an alarm operation value $P_{20BJDZT}$ and/or a lockout operation value $P_{20BSDZT}$ of the gas density relay at a temperature value $T$ based on the alarm contact operation pressure value $P_{TBJDZ}$ and/or the lockout contact operation pressure value $P_{TBSDZ}$ and the temperature value $T$ by conversion according to a pressure-temperature characteristic relation of a gas to be detected; and

calibrating the gas density relay according to the alarm operation value $P_{20BJDZT}$ and/or the lockout operation value $P_{20BSDZT}$,

wherein $P_{20DZCS}$ and/or $P_{20FZCS}$ are/is obtained in advance by performing a contact operation value test and a simulative signal operation value test on the gas density relay at the normal temperature, respectively; and the conversion according to the pressure-temperature characteristic relation of the gas to be detected comprises a calculation by Beattie-Bridgman equation.

Further, the simulative detection signal value $P_{TFZDZ}$ of the gas density relay is obtained in such a manner that a contact operation driving unit outputs a driving signal for driving a simulative detection unit to output a simulative detection signal.

Further, the compensation quantity $\Delta P$ is calculated by the following formula:

$$\Delta P = P_{20FZCS} - P_{TFZDZ}.$$

Further, the alarm contact operation pressure value $P_{TBJDZ}$ and/or the lockout contact operation pressure value $P_{TBSDZ}$ are/is respectively calculated by the following formulas:

$$P_{TBJDZ} = P_{20BJDZCS} - \Delta P$$

$$P_{TBSDZ} = P_{20BSDZCS} - \Delta P.$$

Further, the method also includes:
obtaining an ideal alarm operation pressure value $P_{TLXBJDZ}$ and/or an ideal lockout operation pressure value $P_{TLXBSDZ}$ of the gas density relay at the temperatre $T$ based on the alarm contact operation value $P_{20BJDZCS}$ and/or the lockout contact operation value $P_{20BSDZCS}$ of the gas density relay at the normal temperature by conversion according to the pressure-temperature characteristic relation of the gas to be detected.

Further, an ideal alarm compensation quantity $\Delta P_{LXBJ}$ and/or an ideal lockout compensation quantity $\Delta P_{LXBS}$ are/is calculated according to the ideal alarm operation pressure value $P_{TLXBJDZ}$ and/or the ideal lockout operation pressure value $P_{TLXBSDZ}$, and the alarm contact operation value $P_{20BJDZCS}$ and/or the lockout contact operation value $P_{20BSDZCS}$ of the gas density relay at the normal temperature.

Further, the ideal alarm compensation quantity $\Delta P_{LXBJ}$ and/or the ideal lockout compensation quantity $\Delta P_{LXBS}$ are/is respectively calculated by the following formulas:

$$\Delta P_{LXBJ} = P_{20BJDZCS} - P_{TLXBJDZ}$$

$$\Delta P_{LXBS} = P_{20BSDZCS} - P_{TLXBSDZ}.$$

Further, an alarm compensation quantity error value $\Delta P_{WZBJ}$ and/or a lockout compensation quantity error value $\Delta P_{WZBS}$ are calculated according to the compensation quantity $\Delta P$ and the ideal alarm compensation quantity $\Delta P_{LXBJ}$ and/or the ideal lockout compensation quantity $\Delta P_{LXBS}$ , respectively:

$$\Delta P_{WZBJ} = \Delta P - \Delta P_{LXBJ}$$

$$\Delta P_{WZBS} = \Delta P - \Delta P_{LXBS}.$$

Further, the alarm operation value $P_{20BJDZT}$ and/or the lockout operation value $P_{20BSDZT}$ of the gas density relay at the temperature value T are/is obtained according to the alarm contact operation value $P_{20BJDZCS}$ and/or the lockout contact operation value $P_{20BSDZCS}$ of the gas density relay at the normal temperature, and the alarm compensation quantity error value $\Delta P_{WZBJ}$ and/or the lockout compensation quantity error value $\Delta P_{WZBS}$.

$$P_{20BJDZT} = P_{20BJDZCS} - \Delta P_{WZBJ}$$

$$P_{20BSDZT} = P_{20BSDZCS} - \Delta P_{WZBS}.$$

According to another aspect of the present disclosure, provided is a device for simulative calibration of a gas density relay, including:

a compensation quantity calculation module configured to obtain a simulative detection signal value $P_{TFZDZ}$ of the gas density relay at a temperature T, and obtain a compensation quantity $\Delta P$ at the temperature T according to the simulative detection signal value $P_{TFZDZ}$ and a simulative detection signal value $P_{20FZCS}$ of the gas density relay at a normal temperature;

a contact operation pressure value calculation module configured to obtain an alarm contact operation pressure value $P_{TBJDZ}$ and/or a lockout contact operation pressure value $P_{TBSDZ}$ of the gas density relay at the temperature $T$ according to the compensation quantity $\Delta P$ and an alarm contact operation value $P_{20BJDZCS}$ and/or a lockout contact operation value $P_{20BSDZCS}$ of the gas density relay at the normal temperature; and

an operation value calculation module configured to obtain an alarm operation value $P_{20BJDZT}$ and/or a lockout operation value $P_{20BSDZT}$ of the gas density relay at a temperature value $T$ based on the alarm contact operation pressure value $P_{TBJDZ}$ and/or the lockout contact operation pressure value $P_{TBSDZ}$ and the temperature value $T$ by conversion according to a pressure-temperature characteristic relation of a gas to be detected,

wherein $P_{20DZCS}$ and $P_{20FZCS}$ are obtained in advance by performing a contact operation value test and a simulative signal operation value test on the gas density relay at the normal temperature, respectively; and the conversion according to the pressure-temperature characteristic relation of the gas to be detected comprises a calculation by Beattie-Bridgman equation.

Further, the device further includes a calibration module configured to calibrate the gas density relay according to the alarm operation value $P_{20BJDZT}$ and/or the lockout operation value $P_{20BSDZT}$.

In conclusion, the embodiments of the present disclosure provide a method and device for simulative calibration of a gas density relay. The method includes: obtaining the simulative detection signal value of the gas density relay at the temperature T, and obtaining the compensation quantity at the temperature $T$ according to the simulative detection signal value and the simulative detection signal value of the gas density relay at the normal temperature; obtaining an alarm contact operation pressure value and the lockout contact operation pressure value of the gas density relay at the temperature $T$ according to the compensation quantity and the alarm contact operation value and/or the lockout contact operation value of the gas density relay at the normal temperature; obtaining an alarm operation value and a lockout operation value of the gas density relay at a temperature value $T$ based on the alarm contact operation pressure value and the lockout contact operation pressure value and the temperature value $T$ by conversion according to the pressure-temperature characteristic relation of the gas to be detected; and calibrating the gas density relay according to the alarm operation value and the lockout operation value. The technical solutions of the embodiments of the present disclosure allow for calibration of the gas density relay with the simulative detection signals and do not require disassembly of the gas density relay. The detection process is safe without manual intervention, and the obtained calibration result is highly accurate.

## Brief Description of the Drawings

FIG. 1 is a schematic diagram of a working principle of a gas density relay involved in an embodiment of the present disclosure;

FIG. 2 is a schematic structural diagram of a device for simulative calibration of a gas density relay provided by an embodiment of the present disclosure; and

FIG. 3 is a flowchart of a method for simulative calibration of a gas density relay provided by an embodiment of the present disclosure.

## Detailed Description of the Invention

To make the objective, technical solutions, and advantages of the present disclosure clearer, the present disclosure will be further described in detail below with reference to specific embodiments and the accompanying drawings. It should be understood that these descriptions are merely exemplary and are not intended to limit the scope of the present disclosure. Furthermore, in the following description, descriptions of well-known structures and technologies are omitted to avoid unnecessarily confusing the concepts of the present disclosure.

It needs to be noted that unless otherwise defined, the technical and scientific terms used in one or more embodiments of the present disclosure shall be construed in their ordinary meanings as understood by a person of ordinary skill in the art to which the present disclosure pertains. Terms such as "first" and "second" used in one or more embodiments of the present disclosure do not denote any order, quantity or importance, but are merely intended to distinguish between different constituents. Terms such as "comprising" and "including" mean that elements or articles appearing before "comprising" or "including" include the elements or articles and their equivalent elements appearing behind "comprising" or "including", not excluding any other elements or articles. Phrases such as "connected to" and "connected with" are not restricted to physical or mechanical connections, but may include electrical connections, whether direct or indirect. Terms such as "upper", "lower", "left", and "right" are used only to indicate a relative positional relationship, and when the absolute position of the described object is changed, the relative positional relationship is also changed accordingly.

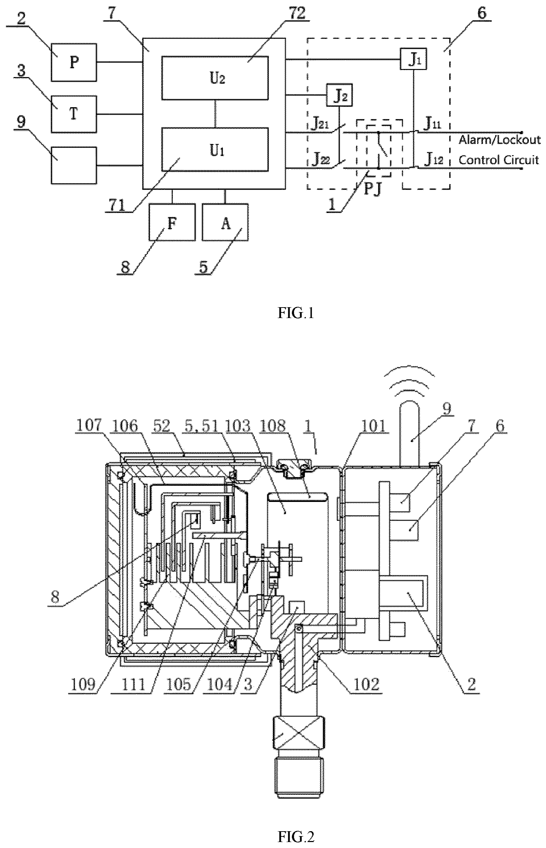

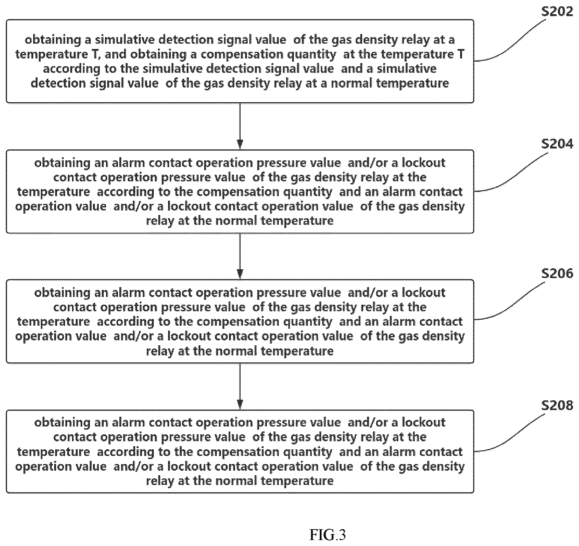

The technical solutions of the present disclosure are described in detail below with reference to the drawings. An embodiment of the present disclosure provides a method for simulative calibration of a gas density relay. FIG. 1 illustrates a schematic diagram of a working principle of a gas density relay involved in an embodiment of the present disclosure. The gas density relay includes a gas density relay body 1 and a gas density detection sensor. The gas density detection sensor includes, for example, a pressure sensor 2 and a temperature sensor 3. The gas density relay is connected to electrical equipment to be detected so as to detect the $SF_6$ gas density of the electrical equipment to be detected. A microprocessor 71 and a power source 72 are further included. The gas density relay body 1 includes a pointer for indicating a gas density. The gas density detection sensor is configured to detect a pressure and a temperature of the electrical equipment to be detected by using the pressure sensor 2 and the temperature sensor 3. The gas density of the electrical equipment to be detected may be calculated by a preset calculation method. The gas density relay further includes a contact operation driving unit 5, a signal sampling unit 6, an intelligent control unit 7, a simulative detection unit 8, and a communication unit 9. The signal sampling unit 6 includes a first connecting circuit and a second connecting circuit. The first connecting circuit is configured to connect a contact of the gas density relay body 1 with a contact signal control circuit, and the second connecting circuit is configured to connect the contact of the gas density relay body 1 with the intelligent control unit 7. In a non-calibration state, the second connecting circuit is opened and the first connecting circuit is closed. In a calibration state, the signal sampling unit 6 opens the first connecting circuit and closes the second connecting circuit such that the contact of the gas density relay body 1 is connected to the intelligent control unit 7. The first connecting circuit includes a first electromagnetic relay J1, and the second connecting circuit includes a second electromagnetic relay J2. The first electromagnetic relay J1 is provided with normally closed contacts J11 and J12 that are connected in series in the contact signal control circuit. The second electromagnetic relay J2 is provided with normally open contacts J21 and J22 that are connected to the contact PJ of the gas density relay body 1. The first electromagnetic relay J1 and the second electromagnetic relay J2 may alternatively be integrated, forming an intermediate relay with normally open and closed contacts. In the non-calibration state, the normally closed contacts J11 and J12 are closed, while the normally open contacts J21 and J22 are opened, and the gas density relay monitors an output state of the contact PJ in real time. In the calibration state, the normally closed contacts J11 and J12 are opened, while the normally open contacts J21 and J22 are closed, and the contact PJ of the gas density relay body 1 is connected to the intelligent control unit 7 via the normally open contacts J21 and J22. Thus, a contact operation value of the gas density relay may be calibrated and tested by using the intelligent control unit 7, the gas density detection sensor (i.e., the pressure sensor 2 and the temperature sensor 3), the contact operation driving unit 5, and the signal sampling unit 6 without powering off the electrical equipment. The contact PJ of the gas density relay body 1 outputs an alarm or lockout signal according to the measured gas density value. The simulative detection unit 8 may be a simulative annunciator, an angle sensor, a position sensor, or photoelectric sensor. In this embodiment of the present disclosure, the simulative detection unit 8 is the simulative annunciator and is configured to acquire a simulative detection signal output by the corresponding simulative annunciator when the gas density monitored by the gas density relay body 1 changes to a set value. The simulative annunciator includes one or more of a microswitch, an electric contact, a mercury switch, an optoelectronic switch, a reed switch, a proximity switch, an electronic switch, a photoelectric sensor, a variable resistor, and a voltage or current measurer. The simulative detection signal includes one of a switch quantity signal, a digital quantity signal, and an analog quantity signal. In this embodiment of the present disclosure, the switch quantity signal is used as the simulative detection signal. The simulative detection unit 8 may be the electric contact, e.g., an ordinary electric contact or a magnetically assisted electric contact. FIG. 2 illustrates a schematic structural diagram of a device for simulative calibration of a gas density relay provided by an embodiment of the present disclosure. As shown in FIG. 2, the device includes: a gas density relay body 1, a gas density detection sensor (i.e., a pressure sensor 2 and a temperature sensor 3), an intelligent control unit 7, a simulative detection unit 8, and a communication unit 9. The pressure sensor 2, the temperature sensor 3, and the intelligent control unit 7 are arranged within the gas density relay body 1. In a gas circuit, the pressure sensor 2 of the gas density detection sensor communicates with the gas density relay body 1. The pressure sensor 2, the temperature sensor 3, the simulative detection unit 8, and the communication unit 9 are separately connected to the intelligent control unit 7. The gas density relay body 1 includes a housing 101, and a base 102, an end seat 108, a pressure detection element 103, a temperature compensation element 104, a plurality of signal generators 109 (for outputting contact signals), a signal actuating mechanism 111, a movement 105, a pointer 106, and an index dial 107 arranged within the housing 101. The simulative detection unit 8 and the communication unit 9 are arranged within the housing 101 of the gas density relay body 1 and are each connected to the intelligent control unit 7, and an antenna of the communication unit is arranged outside the housing 101. One end of the pressure detection element 103 is fixed to and communicates with the base 102, while the other end of the pressure detection element 103 is connected to one end of the temperature compensation element 104 via the end seat 108, and the other end of the temperature compensation element 104 is connected to the movement. The pointer is arranged at a front end of a center shaft of the movement. In this embodiment, the simulative detection unit 8 is an electric contact, typically an ordinary electric contact or a magnetically assisted electric contact. The movement 105 is fixed to the base 102. The other end of the temperature compensation element 104 is connected to the movement 105. The pointer 106 is mounted on the movement 105 and arranged in front of the index dial 107. The pointer 106 is combined with the index dial 107 to display a gas density value. The signal generator 109 includes a magnetically assisted electric contact or a microswitch, and the gas density relay body 1 may output a contact signal via the signal generator 109. The pressure detection element 103 includes a Bourdon tube or a corrugated tube. In this embodiment, the Bourdon tube is used. The temperature compensation element 104 is a temperature compensation plate or a gas enclosed in the housing. In this embodiment, the temperature compensation plate is used. The gas density relay body 1 in this temperature may further include: an oil-filled density relay, an oil-free density relay, a gas density meter, a gas density switch, or a gas pressure meter. The simulative detection unit 8 is arranged on the inner shell of the housing 101. The simulative detection unit 8 may be a simulative annunciator, an angle sensor (or a position sensor, or a photoelectric sensor). In this embodiment, the simulative detection unit 8 is the simulative annunciator and is configured to acquire a simulative detection signal output by the corresponding simulative annunciator when the gas density monitored by the gas density relay body 1 changes to a set value. In the example as shown in FIG. 2, 3 pairs of magnetically assisted electric contacts are adopted, serving as an alarm contact signal, a lockout contact signal, and the simulative detection unit 8, respectively. When the monitored gas density changes to a set value, the simulative detection unit 8 outputs a switch quantity signal as the simulative detection signal. The simulative detection unit 8 is arranged on the magnetically assisted electric contact (e.g., the signal generator 109) of the gas density relay. When the monitored gas density changes to the set value, as shown in FIG. 1, the simulative detection unit 8 outputs a switch quantity signal as the simulative detection signal to the intelligent control unit 7. Upon acquiring the signal, the intelligent control unit 7 immediately acquires data such as the gas density value via the gas density detection sensor (i.e., the pressure sensor 2 and the temperature sensor 3). That is, the intelligent control unit 7 is separately connected to the gas density detection sensor (i.e., the pressure sensor 2 and the temperature sensor 3) and the simulative detection unit 8 to receive data and/or signals acquired by the gas density detection sensor (i.e., the pressure sensor 2 and the temperature sensor 3) and/or the simulative detection unit 8. A new (or real-time) contact operation value is then calculated in conjunction with preset (stored) contact operation value $P_{20DZCS}$ at the temperature of 20°C and simulative detection signal value $P_{20FZCS}$ at the temperature of 20°C as well as the monitored simulative detection signal value and according to a relevant characteristic relation. Thus, the simulative calibration of the density relay is completed. The contact operation driving unit 5 is configured to output a driving signal for driving the simulative detection unit 8 to output a simulative detection signal. Fluctuations in ambient temperature or the contact operation driving unit 5 (e.g., natural temperature fluctuations may alternatively include heating or pressure adjustment, etc.) may drive the simulative detection unit 8 to output the simulative detection signal. The contact operation driving unit 5 includes a heating element 51 and a thermal insulator 52. The heating element 51 and the thermal insulator 52 are separately arranged on the housing 101 of the gas density relay. As shown in FIG. 1, in the circuit, the contact operation driving unit 5 is connected to the intelligent control unit 7. That is, the intelligent control unit 7 controls the circuit of the heating element 51 of the contact operation driving unit 5 to be closed such that the heating element 51 heats the temperature compensation element 104 of the gas density relay, urging the simulative detection unit 8 to output a switch quantity signal as the simulative detection signal to the intelligent control unit 7.

As shown in FIG. 1, the intelligent control unit 7 is separately connected to the gas density detection sensor (i.e., the pressure sensor 2 and the temperature sensor 3), the simulative detection unit 8, and the contact operation driving unit 5. The intelligent control unit 7 is capable of acquiring a gas density value via the gas density detection sensor (i.e., the pressure sensor 2 and the temperature sensor 3). The intelligent control unit 7 controls the circuit of the heating element 51 of the contact operation driving unit 5 to be closed such that the heating element 51 heats the temperature compensation element 104 of the gas density relay, urging the simulative detection unit 8 to output a switch quantity signal as the simulative detection signal to the intelligent control unit 7. The simulative annunciator includes one or more of a microswitch, an electric contact, a mercury switch, an optoelectronic switch, a reed switch, a proximity switch, an electronic switch, a photoelectric sensor, a variable resistor, and a voltage or current measurer. The simulative detection signal includes one of a switch quantity signal, a digital quantity signal, and an analog quantity signal. In this embodiment, the switch quantity signal is adopted. A set value of the simulative detection signal output by the simulative annunciator is 90% to 110% of a rated pressure value Pe of the density relay, i.e., the set value of the simulative detection signal output by the simulative annunciator = (90% to 110%)*Pe.

The working principle is as follows. Specifically, the intelligent control unit 7 (or a background) has a contact operation value $P_{20DZCS}$ at the temperature of 20°C set (stored) thereon; and the intelligent control unit 7 (or the background) has a simulative detection signal value $P_{20FZCS}$ at the temperature of 20°C set (stored) thereon. The intelligent control unit 7 is separately connected to the gas density detection sensor (i.e., the pressure sensor 2 and the temperature sensor 3) and the simulative detection unit 8 to receive data and/or signals acquired by the gas density detection sensor (i.e., the pressure sensor 2 and the temperature sensor 3) and/or the simulative detection unit 8. A new (or real-time) contact operation value is then calculated in conjunction with preset (stored) contact operation value $P_{20DZCS}$ and simulative detection signal value $P_{20FZCS}$ at the temperature of 20°C as well as the monitored simulative detection signal value and according to a relevant characteristic relation. Thus, the simulative calibration of the density relay is completed. The contact operation value of the gas density relay at the normal temperature (usually referring to 20°C) obtained by pre-testing may specifically include an alarm contact operation value and a lockout contact operation value. The alarm contact operation value is denoted by $P_{20BJDZCS}$, i.e., $P_{20BJDZCS}$ being obtained in advance by testing the alarm contact operation value of the gas density relay at the normal temperature. The lockout contact operation value is denoted by $P_{20BSDZCS}$, i.e., $P_{20BSDZCS}$ being obtained in advance by testing the lockout contact operation value of the gas density relay at the normal temperature.

FIG. 3 illustrates a flowchart of a method for simulative calibration of a gas density relay. As shown in FIG. 3, the method includes the following steps.

At S202, a simulative detection signal value $P_{TFZDZ}$ of the gas density relay at a temperature T is obtained, and a compensation quantity $\Delta P$ at the temperature T is obtained according to the simulative detection signal value $P_{TFZDZ}$ and a simulative detection signal value $P_{20FZCS}$ of the gas density relay at a normal temperature. The simulative detection signal value $P_{TFZDZ}$ may be obtained in such a manner that a contact operation driving unit outputs a driving signal for driving a simulative detection unit to output a simulative detection signal. In this step, the compensation quantity $\Delta P$ may be calculated by the following formula:

$$\Delta P = P_{20FZCS} - P_{TFZDZ}.$$

At S204, an alarm contact operation pressure value $P_{TBJDZ}$ and a lockout contact operation pressure value $P_{TBSDZ}$ of the gas density relay at the temperature $T$ is obtained according to the compensation quantity $\Delta P$, and an alarm contact operation value $P_{20BJDZCS}$ and a lockout contact operation value $P_{20BSDZCS}$ of the gas density relay at the normal temperature. In this step, the alarm contact operation pressure value $P_{TBJDZ}$ and the lockout contact operation pressure value $P_{TBSDZ}$ are respectively calculated by the following formulas:

$$P_{TBJDZ} = P_{20BJDZCS} - \Delta P$$

$$P_{TBSDZ} = P_{20BSDZCS} - \Delta P.$$

At S206, an alarm operation value $P_{20BJDZT}$ and a lockout operation value $P_{20BSDZT}$ of the gas density relay at a temperature value $T$ are obtained based on the alarm contact operation pressure value $P_{TBJDZ}$ and the lockout contact operation pressure value $P_{TBSDZ}$ as well as the temperature value $T$ by conversion according to a pressure-temperature characteristic relation of a gas to be detected.

At S208, the gas density relay is calibrated according to the alarm operation value $P_{20BJDZT}$ and the lockout operation value $P_{20BSDZT}$.

$P_{20DZCS}$ and $P_{20FZCS}$ are obtained in advance by performing a contact operation value test and a simulative signal operation value test on the gas density relay at the normal temperature when leaving the factory, respectively; and the conversion according to the pressure-temperature characteristic relation of the gas to be detected includes a calculation by Beattie-Bridgman equation. In an embodiment of the present disclosure, the normal temperature condition refers to a temperature condition in an environment at 20°C.

The following description is made by taking a gas density relay with the following specific parameters as an example: a rated pressure value of 0.6 MPa, an alarm pressure value of 0.55 MPa, and a lockout pressure value of 0.50 MPa. A set value of the simulative detection signal output by the simulative detection unit 8 is 0.58 MPa (the set value of the simulative detection signal output by the simulative annunciator = (90% to 110%)*Pe). The factory calibration is conducted in the environment at 20°C, and the gas density relay is tested with respect to alarm and lockout contact operation values and simulative detection signal values at the temperature of 20°C. It is assumed that in the environment at 20°C, the alarm contact operation value is $P_{20BJDZCS} = 0.5553$ $MPa$, the lockout contact operation value is $P_{20BSDZCS} = 0.5065$ MPa, and the simulative detection signal value is $P_{20FZCS} = 0.5824$ M. Moreover, all the pre-tested data is stored on an intelligent control unit 7 (or an upper computer). After the gas density relay operates for a period of time, during the operation of the gas density relay, it is assumed on site that the intelligent control unit 7 receives a pressure value and a temperature value from the gas density detection sensor (i.e., a pressure sensor 2 and a temperature sensor 3) and obtains a gas density value $P_{20XZ}$ of a gas in a gas chamber of electrical equipment at the current moment by conversion. Thus, the gas density value of the electrical equipment may be monitored in real time, and the online monitoring of the gas density in the gas chamber of the electrical equipment is completed. Simulative calibration may be performed on the contact of the gas density relay. Specifically, a contact operation driving unit 5 may drive a simulative detection unit 8 to output the simulative detection signal. For example, when the contact operation driving unit 5 is heated to the temperature T=51.43°C, the simulative detection unit 8 outputs the simulative detection signal, and at this point, the pressure value is $P_{TFZDZ} = 0.6802$ MPa. In this case, the alarm operation value $P_{20BJDZT}$ of the alarm contact is calculated as follows. A compensation quantity $\Delta P$ at the temperature T (=51.43°C) is obtained:

$$\Delta P = P_{20FZCS} - P_{TFZDZ} = 0.5824 - 0.6802 = -0.0978 \text{ MPa}$$

Accordingly, an alarm contact operation pressure value $P_{TBJDZ}$ at the temperature T (=51.43°C) is obtained:

$$P_{TBJDZ} = P_{20BJDZCS} - \Delta P = 0.5553 - (-0.0978) = 0.6531 \text{ MPa}$$

Then, according to the alarm contact operation pressure value $P_{TBJDZ}$ and the temperature value T = -51.43°C as well as the gas pressure-temperature characteristic relation, conversion may be performed specifically according to the Beattie-Bridgman equation, i.e., the Beattie-Bridgman equation of the $SF_6$ gas state parameter. The Beattie-Bridgman equation is shown below:

$$p = (RTB - A)d^2 + RTd$$
$$A = 73.882 \times 10^{-5} - 5.132105 \times 10^{-7}d$$
$$B = 2.50695 \times 10^{-3} - 2.12283 \times 10^{-6}d$$
$$R = 56.9502 \times 10^{-5}$$

$p$ represents an absolute pressure ($\times$0.1 MPa), $d$ represents a density (kg/m$^3$), and $T$ represents a temperature (K).

The operation value $P_{20BJDZT}$ of the contact at the temperature T (=51.43°C) may be obtained by conversion according to the Beattie-Bridgman equation.

$$P_{20BJDZT} = F(T, P_{TBJDZ}) = F(51.43°C, 0.6531 \text{ MPa}) = 0.5666 \text{ MPa}$$

Thus, the simulative calibration on the alarm contact of the density relay is completed.

For other gases, e.g., an $SF_6/N_2$ mixed gas, a state equation of the $SF_6/N_2$ mixed gas is calculated using Dalton's law of partial pressures, Beattie-Bridgman equation, or an ideal gas state equation.

Likewise, for the simulative calculation of the lockout contact, the compensation quantity $\Delta P$ at the temperature T (=51.43°C) is obtained:

$$\Delta P = P_{20FZCS} - P_{TFZDZ} = 0.5824 - 0.6802 = -0.0978 \text{ MPa}$$

Accordingly, the lockout contact operation pressure value $P_{TBSDZ}$ at the temperature T (=-51.43°C) is obtained:

$$P_{TBSDZ} = P_{20BSDZCS} - \Delta P = 0.5065 - (-0.0978) = 0.6043 \text{MPa}$$

Then, according to the lockout contact operation pressure value $P_{TBSDZ}$=0.6043 MPa and the temperature value T = 51.43°C as well as the gas pressure-temperature characteristic relation, the operation value $P_{20BSDZT}$ of the contact at the temperature T (= 51.43°C) may be obtained specifically by conversion according to the Beattie-Bridgman equation, i.e., the Beattie-Bridgman equation of the $SF_6$ gas state parameter:

$$P_{20BSDZT} = F(T, P_{TBSDZ}) = F(51.43°C, 0.6043 \text{ MPa}) = 0.5243 \text{ MPa}$$

Thus, the simulative calibration on the lockout contact of the density relay is completed.

Furthermore, $P_{20TFZDZ}$ for the lockout contact is obtained based on the pressure value $P_{TFZDZ}$=0.6802 MPa and the temperature value $T$=51.43°C by conversion according to Beattie-Bridgman equation.

$$P_{20TFZDZ} = F(T, P_{TFZDZ}) = F(51.43°C, 0.6802 \text{ MPa}) = 0.59 \text{ MPa}$$

In addition, the simulative detection signal value at the temperature T (=-51.43°C) is 0.59 MPa. This value may alternatively be used as a basis for determining the performance of the gas density relay. The intelligent control unit 7 (or the background) may determine the performance of the density relay by comparison according to historical data before and after monitoring. Therefore, a performance change trend or an aging trend of the density relay may be determined. In particular, a data change quantity $\triangle$Pb before and after testing may be obtained by comparison of the data before and after monitoring, e.g., last test data Pn, previous corresponding test data Po, and a time interval $\triangle$T between tests, $\triangle$Pb=Pn-Po,

and a data change rate $\triangle Vp=(Pn-Po)/\triangle T$ may be known. The performance of the gas density relay may be determined according to the data change quantity $\triangle Pb$ and the data change rate $\triangle Vp$. The service life of the gas density relay may be known according to an allowable maximum change quantity.

As such, simulative calibration and diagnosis may be performed on the contacts of the density relay to ensure the performance of the density relay. When the contact operation values of the density relay obtained by the simulative calibration and diagnosis exceed required errors, abnormal alarm information is sent to the background.

According to some optional embodiments, the method further includes the following step: obtaining an ideal alarm operation pressure value $P_{TLXBJDZ}$ and an ideal lockout operation pressure value $P_{TLXBSDZ}$ of the gas density relay at the temperatre $T$ based on the alarm contact operation value $P_{20BJDZCS}$ and the lockout contact operation value $P_{20BSDZCS}$ of the gas density relay at the normal temperature by conversion according to the pressure-temperature characteristic relation of the gas to be detected.

An ideal alarm compensation quantity $\Delta P_{LXBJ}$ and an ideal lockout compensation quantity $\Delta P_{LXBS}$ are calculated according to the ideal alarm operation pressure value $P_{TLXBJDZ}$ and the ideal lockout operation pressure value $P_{TLXBSDZ}$, and the alarm contact operation value $P_{20BJDZCS}$ and the lockout contact operation value $P_{20BSDZCS}$ of the gas density relay at the normal temperature:

$$\Delta P_{LXBJ}=P_{20BJDZCS}-P_{TLXBJDZ}$$

$$\Delta P_{LXBS}=P_{20BSDZCS}-P_{TLXBSDZ}.$$

An alarm compensation quantity error value $\Delta P_{WZBJ}$ and a lockout compensation quantity error value $\Delta P_{WZBS}$ are calculated according to the compensation quantity $\Delta P$, and the ideal alarm compensation quantity $\Delta P_{LXBJ}$ and the ideal lockout compensation quantity $\Delta P_{LXBS}$, respectively:

$$\Delta P_{WZBJ}=\Delta P-\Delta P_{LXBJ}$$

$$\Delta P_{WZBS}=\Delta P-\Delta P_{LXBS}.$$

The alarm operation value $P_{20BJDZT}$ and the lockout operation value $P_{20BSDZT}$ of the gas density relay at the temperature value $T$ are obtained according to the alarm contact operation value $P_{20BJDZCS}$ and the lockout contact operation value $P_{20BSDZCS}$ of the gas density relay at the normal temperature, and the alarm compensation quantity error value $\Delta P_{WZBJ}$ and the lockout compensation quantity error value

$$\Delta P_{WZBS}:$$

$$P_{20BJDZT}=P_{20BJDZCS}-\Delta P_{WZBJ}$$

$$P_{20BSDZT}=P_{20BSDZCS}-\Delta P_{WZBS}.$$

The following description is made by taking a gas density relay with the following specific parameters as an example: a rated pressure value of 0.6 MPa, an alarm pressure value of 0.55 MPa, and a lockout pressure value of 0.50 MPa. A set value of the simulative detection signal output by the simulative detection unit 8 is 0.58 MPa (the set value of the simulative detection signal output by the simulative annunciator = (90% to 110%)*Pe). The factory calibration is conducted in the environment at 20°C, and the gas density relay is tested with respect to alarm and lockout contact operation values and simulative detection signal values at the temperature of 20°C. For example, in the environment at 20°C, the alarm contact operation value is $P_{20BJDZCS}=0.5553\,MPa$, the lockout contact operation value is $P_{20BSDZCS}=0.5065$ MPa, and the simulative detection signal value is $P_{20FZCS}=0.5824$ M. Moreover, all the pre-tested data is stored on an intelligent control unit 7 (or an upper computer). After the gas density relay operates for a period of time, during the operation of the gas density relay, it is assumed on site that the intelligent control unit 7 receives a pressure value and a temperature value from the gas density detection sensor (i.e., a pressure sensor 2 and a temperature sensor 3) and obtains a gas density value $P_{20XZ}$ of a gas in a gas chamber of electrical equipment at the current moment by conversion. Thus, the gas density value of the electrical equipment may be monitored in real time.

Simulative calibration may be performed on the contact of the gas density relay. Specifically, a contact operation driving unit 5 may drive a simulative detection unit 8 to output the simulative detection signal. For example, when the contact operation driving unit 5 is heated to the temperature T=51.43°C, the simulative detection unit 8 outputs the simulative detection signal, and at this point, the pressure value is $P_{TFZDZ}=0.6802$ MPa. In this case, the alarm operation value $P_{20BJDZT}$ of the alarm contact is calculated as follows. The compensation quantity $\Delta P$ at the temperature (=51.43°C) is obtained:

$$\Delta P = P_{20FZCS} - P_{TFZDZ} = 0.5824 - 0.6802 = -0.0978 \text{ MPa}$$

Then, according to the alarm contact operation pressure value $P_{20BJDZCS}$ at the normal temperature (20°C in this embodiment) and the temperature value T = 51.43°C as well as the gas pressure-temperature characteristic relation, the ideal alarm operation pressure value $P_{TLXBJDZ}$ of the contact at the temperature T (= 51.43°C) may be obtained specifically by conversion according to the Beattie-Bridgman equation, i.e., the Beattie-Bridgman equation of the SF$_6$ gas state parameter:

$$P_{TLXBJDZ} = 0.6401 \text{ MPa}$$

The ideal alarm compensation quantity $\Delta P_{LXBJ}$ is obtained:

$$\Delta P_{LXBJ} = P_{20BJDZCS} - P_{TLXBJDZ} = 0.5553 - 0.6401 = -0.0848 \text{ MPa}$$

Thus, the compensation quantity error $\Delta P_{WZBJ}$ is obtained:

$$\Delta P_{WZBJ} = \Delta P - \Delta P_{LXBJ} = -0.0978 - (-0.0848) = -0.013 \text{ MPa}$$

Accordingly, the alarm contact operation value $P_{20BJDZT}$ at the temperature T may be obtained:

$$P_{20BJDZT} = P_{20BJDZCS} - \Delta P_{WZBJ} = 0.5553 - (-0.013) = 0.5683 \text{ MPa}$$

Thus, the simulative calibration on the alarm contact of the gas density relay is completed.

The lockout operation value $P_{20BSDZT}$ of the lockout contact is calculated as follows. The compensation quantity $\Delta P$ at the temperature T (=51.43°C) is obtained:

$$\Delta P = P_{20FZCS} - P_{TFZDZ} = 0.5824 - 0.6802 = -0.0978 \text{ MPa}$$

Then, according to the contact lockout operation pressure value $P_{20BSDZCS}$ at the normal temperature (20°C in this embodiment) and the temperature value T = 51.43°C as well as the gas pressure-temperature characteristic relation, the ideal lockout operation pressure value $P_{TLXBSDZ}$ of the contact at the temperature T (= 51.43°C) may be obtained specifically by conversion according to the Beattie-Bridgman equation, i.e., the Beattie-Bridgman equation of the SF$_6$ gas state parameter:

$$P_{TLXBSDZ} = 0.5839 \text{ MPa}$$

The ideal lockout compensation quantity $\Delta P_{LXBS}$ is obtained:

$$\Delta P_{LXBS} = P_{20BSDZCS} - P_{TLXBSDZ} = 0.5065 - 0.5839 = -0.0774 \text{MPa}$$

Thus, the compensation quantity error $\Delta P_{WZBS}$ is obtained:

$$\Delta P_{WZBS} = \Delta P - \Delta P_{LXBS} = -0.0978 - (-0.0774) = -0.0204 \text{MPa}$$

Accordingly, the lockout contact operation value $P_{20BSDZT}$ at the temperature T may be obtained:

$$P_{20BSDZT} = P_{20BSDZCS} - \Delta P_{WZBS} = 0.5065 \text{ MPa} - (-0.0204) = 0.5269 \text{ MPa}$$

Thus, the simulative calibration on the lockout contact of the gas density relay is completed.

In the calibration method provided by two embodiments of the present disclosure, there are small differences between the simulatively calculated values of the alarm contact and the simulatively calculated values of the lockout contact. These differences are 0.0017 MPa and 0.0026 MPa, and both may be applied to engineering applications.

An embodiment of the present disclosure further provides a device for simulative calibration of a gas density relay, including:

a compensation quantity calculation module configured to obtain a simulative detection signal value $P_{TFZDZ}$ of the gas density relay at a temperature T, and obtain a compensation quantity $\Delta P$ at the temperature T according to the simulative detection signal value $P_{TFZDZ}$ and a simulative detection signal value $P_{20FZCS}$ of the gas density relay at a normal temperature;

a contact operation pressure value calculation module configured to obtain an alarm contact operation pressure value $P_{TBJDZ}$ and a lockout contact operation pressure value $P_{TBSDZ}$ of the gas density relay at the temperature $T$ according to the compensation quantity $\Delta P$ and an alarm contact operation value $P_{20BJDZCS}$ and a lockout contact operation value $P_{20BSDZCS}$ of the gas density relay at the normal temperature;

an operation value calculation module configured to obtain an alarm operation value $P_{20BJDZT}$ and a lockout operation value $P_{20BSDZT}$ of the gas density relay at a temperature value $T$ based on the alarm contact operation pressure value $P_{TBJDZ}$ and the lockout contact operation pressure value $P_{TBSDZ}$ and the temperature value $T$ by conversion according to a pressure-temperature characteristic relation of a gas to be detected; and

a calibration module configured to calibrate the gas density relay according to the alarm operation value $P_{20BJDZT}$ and the lockout operation value $P_{20BSDZT}$,

wherein $P_{20DZCS}$ and $P_{20FZCS}$ are obtained in advance by performing a contact operation value test and a simulative signal operation value test on the gas density relay at the normal temperature when leaving the factory, respectively; and the conversion according to the pressure-temperature characteristic relation of the gas to be detected includes a calculation by Beattie-Bridgman equation. For an $SF_6/N_2$ mixed gas, a state equation of the $SF_6/N_2$ mixed gas may be calculated using Dalton's law of partial pressures, Beattie-Bridgman equation, or an ideal gas state equation.

In the device for simulative calibration of a gas density relay in this embodiment of the present disclosure, the specific manners in which modules implement their functions are the same as the steps of the method for simulative calibration of a gas density relay in the foregoing embodiments. Therefore, redundant descriptions thereof will be omitted herein.

In conclusion, the embodiments of the present disclosure provide a method and device for simulative calibration of a gas density relay. The method includes: obtaining the simulative detection signal value of the gas density relay at the temperature T, and obtaining the compensation quantity at the temperature $T$ according to the simulative detection signal value and the simulative detection signal value of the gas density relay at the normal temperature; obtaining an alarm contact operation pressure value and the lockout contact operation pressure value of the gas density relay at the temperature T according to the compensation quantity and the alarm contact operation value and/or the lockout contact operation value of the gas density relay at the normal temperature; obtaining an alarm operation value and a lockout operation value of the gas density relay at a temperature value $T$ based on the alarm contact operation pressure value and the lockout contact operation pressure value and the temperature value $T$ by conversion according to the pressure-temperature characteristic relation of the gas to be detected; and calibrating the gas density relay according to the alarm operation value and the lockout operation value. The technical solutions of the embodiments of the present disclosure allow for calibration of the gas density relay with the simulative detection signals and do not require disassembly of the gas density relay. The detection process is safe without manual intervention, and the obtained calibration result is highly accurate.

It should be understood that the above specific embodiments of the present disclosure are merely used to illustrate or explain the principles of the present disclosure by way of example, but do not limit the present disclosure. Therefore, any modifications, equivalent substitutions, improvements and the like made without departing from the spirit and scope of the present disclosure should be included in the protection scope of the present disclosure. Furthermore, the appended claims of the present disclosure are intended to cover all changes and modifications that fall within the scope and boundaries, or equivalents of such scope and boundaries of the appended claims.

**Claims**

1. A method for simulative calibration of a gas density relay, comprising:

obtaining a simulative detection signal value $P_{TFZDZ}$ of the gas density relay at a temperature T, and obtaining a compensation quantity $\Delta P$ at the temperature T according to the simulative detection signal value $P_{TFZDZ}$ and a simulative detection signal value $P_{20FZCS}$ of the gas density relay at a normal temperature;

obtaining an alarm contact operation pressure value $P_{TBJDZ}$ and/or a lockout contact operation pressure value $P_{TBSDZ}$ of the gas density relay at the temperature $T$ according to the compensation quantity $\Delta P$ and an alarm contact operation value $P_{20BJDZCS}$ and/or a lockout contact operation value $P_{20BSDZCS}$ of the gas density relay at the normal temperature;

obtaining an alarm operation value $P_{20BJDZT}$ and/or a lockout operation value $P_{20BSDZT}$ of the gas density relay at a temperature value $T$ based on the alarm contact operation pressure value $P_{TBJDZ}$ and/or the lockout contact operation pressure value $P_{TBSDZ}$ and the temperature value $T$ by conversion according to a pressure-temperature characteristic relation of a gas to be detected; and

calibrating the gas density relay according to the alarm operation value $P_{20BJDZT}$ and/or the lockout operation value $P_{20BSDZT}$,

wherein $P_{20DZCS}$ and/or $P_{20FZCS}$ are/is obtained in advance by performing a contact operation value test and a simulative signal operation value test on the gas density relay at the normal temperature, respectively; and the conversion according to the pressure-temperature characteristic relation of the gas to be detected comprises a calculation by Beattie-Bridgman equation.

2. The method according to claim 1, wherein the simulative detection signal value $P_{TFZDZ}$ of the gas density relay is obtained in such a manner that a contact operation driving unit outputs a driving signal for driving a simulative detection unit to output a simulative detection signal.

3. The method according to claim 1, wherein the compensation quantity $\Delta P$ is calculated by the following formula:

$$\Delta P = P_{20FZCS} - P_{TFZDZ}.$$

4. The method according to claim 3, wherein the alarm contact operation pressure value $P_{TBJDZ}$ and/or the lockout contact operation pressure value $P_{TBSDZ}$ are/is respectively calculated by the following formulas:

$$P_{TBJDZ} = P_{20BJDZCS} - \Delta P$$

$$P_{TBSDZ} = P_{20BSDZCS} - \Delta P.$$

5. The method according to claim 1, further comprising: obtaining an ideal alarm operation pressure value $P_{TLXBJDZ}$ and/or an ideal lockout operation pressure value $P_{TLXBSDZ}$ of the gas density relay at the temperatre $T$ based on the alarm contact operation value $P_{20BJDZCS}$ and/or the lockout contact operation value $P_{20BSDZCS}$ of the gas density relay at the normal temperature by conversion according to the pressure-temperature characteristic relation of the gas to be detected.

6. The method according to claim 5, wherein an ideal alarm compensation quantity $\Delta P_{LXBJ}$ and/or an ideal lockout compensation quantity $\Delta P_{LXBS}$ are/is calculated according to the ideal alarm operation pressure value $P_{TLXBJDZ}$ and/or the ideal lockout operation pressure value $P_{TLXBSDZ}$, and the alarm contact operation value $P_{20BJDZCS}$ and/or the lockout contact operation value $P_{20BSDZCS}$ of the gas density relay at the normal temperature.

7. The method according to claim 6, wherein the ideal alarm compensation quantity $\Delta P_{LXBJ}$ and/or the ideal lockout compensation quantity $\Delta P_{LXBS}$ are/is respectively calculated by the following formulas:

$$\Delta P_{LXBJ} = P_{20BJDZCS} - P_{TLXBJDZ}$$

$$\Delta P_{LXBS} = P_{20BSDZCS} - P_{TLXBSDZ}.$$

8. The method according to claim 7, wherein an alarm compensation quantity error value $\Delta P_{WZBJ}$ and/or a lockout compensation quantity error value $\Delta P_{WZBS}$ are calculated according to the compensation quantity $\Delta P$ and the ideal alarm compensation quantity $\Delta P_{LXBJ}$ and/or the ideal lockout compensation quantity $\Delta P_{LXBS}$, respectively:

$$\Delta P_{WZBJ} = \Delta P - \Delta P_{LXBJ}$$

$$\Delta P_{WZBS} = \Delta P - \Delta P_{LXBS}.$$

9. The method according to claim 8, wherein the alarm operation value $P_{20BJDZT}$ and/or the lockout operation value $P_{20BSDZT}$ of the gas density relay at the temperature value $T$ are/is obtained according to the alarm contact operation value $P_{20BJDZCS}$ and/or the lockout contact operation value $P_{20BSDZCS}$ of the gas density relay at the normal temperature, and the alarm compensation quantity error value $\Delta P_{WZBJ}$ and/or the lockout compensation quantity error value $\Delta P_{WZBS}$.

$$P_{20BJDZT}=P_{20BJDZCS}-\Delta P_{WZBJ}$$

$$P_{20BSDZT}=P_{20BSDZCS}-\Delta P_{WZBS}.$$

10. A device for simulative calibration of a gas density relay, comprising:

a compensation quantity calculation module configured to obtain a simulative detection signal value $P_{TFZDZ}$ of the gas density relay at a temperature T, and obtain a compensation quantity $\Delta P$ at the temperature T according to the simulative detection signal value $P_{TFZDZ}$ and a simulative detection signal value $P_{20FZCS}$ of the gas density relay at a normal temperature;
a contact operation pressure value calculation module configured to obtain an alarm contact operation pressure value $P_{TBJDZ}$ and/or a lockout contact operation pressure value $P_{TBSDZ}$ of the gas density relay at the temperature T according to the compensation quantity $\Delta P$ and an alarm contact operation value $P_{20BJDZCS}$ and/or a lockout contact operation value $P_{20BSDZCS}$ of the gas density relay at the normal temperature; and
an operation value calculation module configured to obtain an alarm operation value $P_{20BJDZT}$ and/or a lockout operation value $P_{20BSDZT}$ of the gas density relay at a temperature value T based on the alarm contact operation pressure value $P_{TBJDZ}$ and/or the lockout contact operation pressure value $P_{TBSDZ}$ and the temperature value T by conversion according to a pressure-temperature characteristic relation of a gas to be detected,
wherein $P_{20DZCS}$ and $P_{20FZCS}$ are obtained in advance by performing a contact operation value test and a simulative signal operation value test on the gas density relay at the normal temperature, respectively; and the conversion according to the pressure-temperature characteristic relation of the gas to be detected comprises a calculation by Beattie-Bridgman equation.

11. The device for simulative calibration of a gas density relay according to claim 10, further comprising a calibration module configured to calibrate the gas density relay according to the alarm operation value $P_{20BJDZT}$ and/or the lockout operation value $P_{20BSDZT}$.

FIG.1

FIG.2

14

obtaining a simulative detection signal value of the gas density relay at a temperature T, and obtaining a compensation quantity at the temperature T according to the simulative detection signal value and a simulative detection signal value of the gas density relay at a normal temperature

S202

obtaining an alarm contact operation pressure value and/or a lockout contact operation pressure value of the gas density relay at the temperature according to the compensation quantity and an alarm contact operation value and/or a lockout contact operation value of the gas density relay at the normal temperature

S204

obtaining an alarm contact operation pressure value and/or a lockout contact operation pressure value of the gas density relay at the temperature according to the compensation quantity and an alarm contact operation value and/or a lockout contact operation value of the gas density relay at the normal temperature

S206

obtaining an alarm contact operation pressure value and/or a lockout contact operation pressure value of the gas density relay at the temperature according to the compensation quantity and an alarm contact operation value and/or a lockout contact operation value of the gas density relay at the normal temperature

S208

FIG.3

## INTERNATIONAL SEARCH REPORT

| International application No. |
| --- |
| **PCT/CN2023/080747** |

| A. | CLASSIFICATION OF SUBJECT MATTER |
| --- | --- |

G01R31/327(2006.01)i; H01H35/26(2006.01)i; H01H35/32(2006.01)i

According to International Patent Classification (IPC) or to both national classification and IPC

| B. | FIELDS SEARCHED |
| --- | --- |

Minimum documentation searched (classification system followed by classification symbols)

IPC: G01R, H01H

Documentation searched other than minimum documentation to the extent that such documents are included in the fields searched

Electronic data base consulted during the international search (name of data base and, where practicable, search terms used)

CNABS, CNTXT, CNKI: SF6密度继电器, 气体密度继电器, 六氟化硫密度继电器, 密度继电器, 仿真, 模拟, 虚拟, 校验, 校准, 温度, 补偿, 修正, 接点, 动作, 压力, 无, 不, 拆卸; USTXT, EPTXT, WOTXT, VEN, IEEE: SF6 density relay, gas density relay, density relay, simulation, virtual, check, verify, temperature, compensation, correction, contact, action, pressure, non-disassembly.

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 111446118 A (SHANGHAI ROYE ELECTRIC SCIENCE & TECHNOLOGY CO., LTD.) 24 July 2020 (2020-07-24)<br>description, paragraphs 164-165, and figure 1 | 1-11 |
| A | CN 111443283 A (SHANGHAI ROYE ELECTRIC SCIENCE & TECHNOLOGY CO., LTD.) 24 July 2020 (2020-07-24)<br>entire document | 1-11 |
| A | CN 110542854 A (SHANGHAI ZHUODIAN ELECTRIC CO., LTD.) 06 December 2019 (2019-12-06)<br>entire document | 1-11 |
| A | CN 104299843 A (SHANGHAI ROYE ELECTRIC SCIENCE & TECHNOLOGY CO., LTD.) 21 January 2015 (2015-01-21)<br>entire document | 1-11 |

☑ Further documents are listed in the continuation of Box C. ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 November 2023** | **10 November 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**EP 4 675 288 A1**

## INTERNATIONAL SEARCH REPORT

International application No.

**PCT/CN2023/080747**

### C.    DOCUMENTS CONSIDERED TO BE RELEVANT

| Category* | Citation of document, with indication, where appropriate, of the relevant passages | Relevant to claim No. |
|---|---|---|
| A | CN 111446113 A (SHANGHAI ROYE ELECTRIC SCIENCE & TECHNOLOGY CO., LTD.) 24 July 2020 (2020-07-24)<br>entire document | 1-11 |
| A | CN 110412460 A (SHANGHAI ROYE ELECTRIC SCIENCE & TECHNOLOGY CO., LTD.) 05 November 2019 (2019-11-05)<br>entire document | 1-11 |
| A | CN 212275901 U (ELECTRIC POWER RESEARCH INSTITUTE, STATE GRID JIBEI ELECTRIC POWER COMPANY LIMITED et al.) 01 January 2021 (2021-01-01)<br>entire document | 1-11 |
| A | CN 212675111 U (KUNSHAN ZHIYI INTELLIGENT ELECTRIC CO., LTD.) 09 March 2021 (2021-03-09)<br>entire document | 1-11 |
| A | DE 7110274 U (BBC, BROWN BOVERI & CIE et al.) 08 February 1973 (1973-02-08)<br>entire document | 1-11 |
| A | 曲芳 等 (QU, Fang et al.). "SF6密度继电器现场校验方法探讨 (Non-official translation: Discussion on the On-Site Calibration Method of SF6 Density Relay)"<br>电工技术 (Electric Engineering), No. 3, 10 March 2012 (2012-03-10), pages 23-24<br>text, part 2 | 1-11 |

Form PCT/ISA/210 (second sheet) (July 2022)

## INTERNATIONAL SEARCH REPORT
### Information on patent family members

International application No.

**PCT/CN2023/080747**

| Patent document cited in search report | | | Publication date (day/month/year) | Patent family member(s) | | | Publication date (day/month/year) |
|---|---|---|---|---|---|---|---|
| CN | 111446118 | A | 24 July 2020 | WO | 2021218284 | A1 | 04 November 2021 |
| | | | | EP | 4145484 | A1 | 08 March 2023 |
| | | | | US | 2023221370 | A1 | 13 July 2023 |
| | | | | CN | 211929382 | U | 13 November 2020 |
| | | | | IN | 202247068274 | A | 09 December 2022 |
| CN | 111443283 | A | 24 July 2020 | WO | 2021218288 | A1 | 04 November 2021 |
| | | | | CN | 212646903 | U | 02 March 2021 |
| | | | | IN | 202247068344 | A | 06 January 2023 |
| CN | 110542854 | A | 06 December 2019 | CN | 110542854 | B | 30 November 2021 |
| CN | 104299843 | A | 21 January 2015 | CN | 104299843 | B | 25 January 2017 |
| CN | 111446113 | A | 24 July 2020 | WO | 2021218291 | A1 | 04 November 2021 |
| | | | | US | 2023168302 | A1 | 01 June 2023 |
| | | | | CN | 212136345 | U | 11 December 2020 |
| | | | | IN | 202247068402 | A | 06 January 2023 |
| CN | 110412460 | A | 05 November 2019 | EP | 4027153 | A1 | 13 July 2022 |
| | | | | WO | 2021043037 | A1 | 11 March 2021 |
| | | | | US | 2022334183 | A1 | 20 October 2022 |
| | | | | CN | 210923905 | U | 03 July 2020 |
| CN | 212275901 | U | 01 January 2021 | CN | 111983441 | A | 24 November 2020 |
| CN | 212675111 | U | 09 March 2021 | CN | 111722105 | A | 29 September 2020 |
| DE | 7110274 | U | 08 February 1973 | IT | 947784 | B | 30 May 1973 |
| | | | | NL | 7202281 | A | 28 August 1972 |
| | | | | NL | 155976 | B | 15 February 1978 |
| | | | | US | 3749865 | A | 31 July 1973 |
| | | | | DE | 2113100 | A1 | 07 September 1972 |
| | | | | DE | 2113100 | B2 | 23 November 1978 |
| | | | | FR | 2126236 | A1 | 06 October 1972 |
| | | | | FR | 2126236 | B1 | 02 September 1977 |
| | | | | JPS | 56897 | B1 | 10 January 1981 |
| | | | | CH | 528142 | A | 15 September 1972 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023101906224